# EUROPEAN PATENT APPLICATION

(11) **EP 4 607 958 A1**
(43) Date of publication of application: **27.08.2025**
(21) Application number: 23937228.7
(22) Date of filing: 23.10.2023
(51) Int. Cl.: H04R 9/06, G10K 9/13, G10K 11/172

(54) **LOUDSPEAKER ASSEMBLY AND WEARABLE ELECTRONIC DEVICE**

(30) Priority: 12.05.2023 CN 202310541798
(71) Applicant: Shenzhen Shokz Co., Ltd., Shenzhen, Guangdong 518108 (CN)
(72) Inventor: ZHU, Guangyuan, Shenzhen, Guangdong 518108 (CN); ZHANG, Lei, Shenzhen, Guangdong 518108 (CN); QI, Xin, Shenzhen, Guangdong 518108 (CN)
(74) Representative: Wang, Bo
(86) International application number: PCT/CN2023/126023
(87) International publication number: WO 2024/234553

(57) **Abstract**

A loudspeaker assembly (1) and a wearable electronic device. The loudspeaker assembly (1) comprises a housing assembly (10), a bone conduction loudspeaker (11), and an air conduction loudspeaker (12). The housing assembly (10) is provided with a first accommodating cavity (1001) and a second accommodating cavity (1002); the bone conduction loudspeaker (11) is disposed in the first accommodating cavity (1001); the air conduction loudspeaker (12) is disposed in the second accommodating cavity (1002). The air conduction loudspeaker (12) comprises: a magnetic circuit system (1260); the magnetic circuit system (1260) comprises a magnet (1210) and magnetic conduction assemblies (1220), the magnet (1210) is secured on the magnetic conduction assemblies (1220), the magnetic conduction assemblies (1220) are secured in the second accommodating cavity (1002), and the magnetic conduction assemblies (1220) are each provided with a weight reduction structure (1223). By means of the described arrangement, the overall weight of the air conduction loudspeaker (12) can be effectively reduced, so that the overall weight of the loudspeaker assembly (1) is effectively reduced. On this basis, the working stability of the bone conduction loudspeaker (11) can be effectively improved, and the sound transmission quality of the bone conduction loudspeaker (11) can be effectively improved, thereby effectively improving the sound quality of an earphone (100).

## Description

### TECHNICAL FIELD

The present disclosure relates to the technical field of sound-producing apparatus, and in particular, to earphones.

### BACKGROUND

Earphones have been widely used in people's daily lives, and they can be used in conjunction with electronic devices such as smartphones and computers to provide users with an auditory feast. Currently, both air-conducting sound transmission principle and bone-conducting sound transmission principle have been widely applied in earphones. As a result, current earphones are typically either air-conducting type earphones or bone-conducting type earphones, so that the types of headphones are relatively single, which restricts the potential for sound quality improvement. Furthermore, due to the different sound transmission principles of air-conducting loudspeaker and bone-conducting loudspeaker, the requirements for the installation environment and structure differ. Among these, the overall weight of the loudspeaker assembly in the earphone is a major factor influencing the sound quality of the bone-conducting loudspeaker. Therefore, reducing the overall weight of the loudspeaker assembly to enhance the sound quality of earphones that combine both bone-conducting and air-conducting types is an urgent issue that needs to be addressed.

### SUMMARY

The present disclosure provides a loudspeaker assembly. The loudspeaker assembly comprises a shell assembly, a bone-conducting loudspeaker, an air-conducting loudspeaker, and a magnetic circuit system. The shell assembly is provided with a first accommodation cavity and a second accommodation cavity. The bone-conducting loudspeaker is accommodated in the first accommodation cavity and the air-conducting loudspeaker is accommodated in the second accommodation cavity. The air-conducting loudspeaker includes a magnetic circuit system, and the magnetic circuit system includes a magnet and a magnetic conduction assembly, the magnet being fixed on the magnetic conduction assembly, the magnetic conduction assembly being fixed in the second accommodation cavity, and the magnetic conduction assembly being provided with a weight reduction structure.

In some embodiments, the weight reduction structure includes at least one of a groove or a through hole arranged at the magnetic conduction assembly.

In some embodiments, a magnetic induction intensity at a position of the magnetic conduction assembly where the weight reduction structure is arranged is less than a magnetic induction intensity at other positions of the magnetic conduction assembly.

In some embodiments, the magnetic conduction assembly includes a magnetic conduction shield and a magnetic conduction plate. The magnet is fixed in the magnetic conduction shield and the magnetic conduction plate is fixed to the magnet, the weight reduction structure is arranged on at least one of the magnetic conduction shield or the magnetic conduction plate, there are one or more weight reduction structures on the magnetic conduction shield and the magnetic conduction plate of the magnetic conduction assembly, and a plurality of weight reduction structures are spaced apart.

In some embodiments, the magnetic conduction shield includes a bottom wall and an annular side wall extending from the bottom wall, and the weight reduction structure is arranged at the bottom wall.

In some implementations, a total area of the weight reduction structure on the magnetic conduction shield accounts for less than or equal to 50% of an area of a bottom wall of the magnetic conduction shield, and a total area of the weight reduction structure on the magnetic conduction plate accounts for less than or equal to 50% of an area of the magnetic conduction plate.

In some embodiments, a total area of the weight reduction structure on the magnetic conduction shield accounts for less than or equal to 30% of an area of a bottom wall of the magnetic conduction shield, and a total area of the weight reduction structure on the magnetic conduction plate accounts for less than or equal to 30% of an area of the magnetic conduction plate.

In some embodiments, a planar shape of the weight reduction structure on the magnetic conduction shield is the same as a planar shape of the bottom wall of the magnetic conduction shield and is reduced in equal proportion relative to the planar shape of the bottom wall of the magnetic conduction shield; and a planar shape of the weight reduction structure on the magnetic conduction plate is the same as a planar shape of the magnetic conduction plate and is reduced in equal proportion relative to the planar shape of the magnetic conduction plate.

In some embodiments, the weight reduction structure is centrally arranged at the bottom wall.

In some embodiments, the weight reduction structure is centrally arranged at the magnetic conduction plate.

In some implementations, the weight reduction structure is a through hole.

In some embodiments, the magnet is provided with the weight reduction structure, the weight reduction structure is a groove or through hole.

In some embodiments, a magnetic induction intensity at a position of the magnet where the weight reduction structure is arranged is less than a magnetic induction intensity at other positions of the magnet.

In some embodiments, the weight reduction structure on the magnet is located at a center of the magnet, and a planar shape of the weight reduction structure on the magnet is the same as a planar shape of the magnet and is reduced in equal proportion relative to the planar shape of the magnet.

In some embodiments, a planar area of the weight reduction structure on the magnet accounts for less than or equal to 50% of a planar area of the magnet.

In some implementations, the air-conducting loudspeaker further includes a fixing assembly, the fixing assembly is fixed to the magnetic conduction assembly, and the fixing assembly is fixedly connected to the shell assembly.

In some embodiments, the air-conducting loudspeaker further includes a vibration diaphragm and a voice coil, a rim of the vibration diaphragm is connected to a periphery of the fixing assembly, and the voice coil is connected to the vibration diaphragm.

In some embodiments, the loudspeaker assembly is provided with a pressure relief hole for communicating with the second accommodation cavity and external environment, and the pressure relief hole extends toward a side where the first accommodation cavity is located.

The present disclosure provides a wearable electronic device, comprising the loudspeaker assembly of any one of the above embodiments.

In some embodiments, the wearable electronic device wearable electronic device is earphones, glasses, an AR device, or a VR device.

The beneficial effect of the present disclosure is as follows: with such an arrangement, the overall weight of the air-conducting loudspeaker can be effectively reduced, and accordingly, effectively reducing the overall weight of the loudspeaker assembly, improving the user's experience, and effectively improving the operational stability of the bone-conducting loudspeaker, and improving the sound transmission quality of the bone-conducting loudspeaker, thereby effectively improve the sound quality of the earphone.

It should be appreciated that the above general description and the detailed descriptions that follow are exemplary and explanatory only, and are not intended to limit the present disclosure.

### BRIEF DESCRIPTION OF THE DRAWINGS

In order to more clearly illustrate the technical solutions in the embodiments of the present disclosure, the accompanying drawings that need to be used in the description of the embodiments will be briefly introduced in the following, and it will be obvious that the accompanying drawings in the following description are only some of the embodiments of the present disclosure, and other drawings can be obtained based on them without creative labor to a person of ordinary skill in the art.
FIG. 1 is a schematic diagram illustrating a three-dimensional structure of an earphone according to embodiments of the present disclosure;
FIG. 2 is a schematic diagram illustrating a three-dimensional structure of a loudspeaker assembly and a wearing assembly shown in FIG. 1;
FIG. 3 is an exploded schematic diagram of a structure of the loudspeaker assembly shown in FIG. 2;
FIG. 4 is an exploded schematic diagram of a structure of an air-conducting loudspeaker shown in FIG. 2;
FIG.5 is a schematic diagram illustrating a cross-section of a structure of the air-conducting loudspeaker shown in FIG. 2;
FIG. 6 is a schematic diagram illustrating a three-dimensional structure of a magnetic conduction shield shown in FIG. 4;
FIG. 7 is a schematic diagram illustrating a three-dimensional structure of a magnetic conduction plate shown in FIG. 4;
FIG. 8 is a line graph illustrating a relationship curve between a preset proportion of a total area of a weight reduction structure on the magnetic conduction shield in FIG. 6 to a total area of the magnetic conduction shield and a weight change of the loudspeaker assembly, and a relationship curve between the preset proportion and a sensitivity change of the air-conducting loudspeaker.
FIG. 9 is a schematic diagram illustrating a three-dimensional structure of a magnet shown in FIG. 4;
FIG. 10 is an exploded schematic diagram of a first embodiment of a pressure relief hole protection scheme of the loudspeaker assembly shown in FIG. 2;
FIG. 11 is a schematic diagram illustrating a partially assembled structure of the first embodiment of the pressure relief hole protection scheme shown in FIG. 10;
FIG.12 is a schematic diagram illustrating a three-dimensional structure of a protective mesh shown in FIG. 10;
FIG. 13 is a schematic diagram illustrating a front view of a second embodiment of the pressure relief hole protection scheme of the loudspeaker assembly shown in FIG. 2;
FIG. 14 is a schematic diagram illustrating a sectional structure of an embodiment of a region A shown in FIG. 13; and
FIG. 15 is a schematic diagram illustrating a sectional structure of another embodiment of the region A shown in FIG. 13.

### DETAILED DESCRIPTION

In order to enable those skilled in the art to better understand the technical solutions of the present disclosure, the present disclosure is described in further detail below in conjunction with the accompanying drawings and specific embodiments. It is to be understood that the described embodiments are only a part of the embodiments of the present disclosure, and not all of them. Based on the embodiments in the present disclosure, all other embodiments obtained by a person of ordinary skill in the art without making creative labor fall within the scope of protection of the present disclosure.

The terms "first", "second", etc. in the present disclosure are used to differentiate between different objects and are not used to describe a particular order. Additionally, the terms "comprising" and "including", and any variations thereof, are intended to cover non-exclusive inclusion. For example, a process, method, system, product, or apparatus comprising a series of steps or units is not limited to the listed steps or units, but optionally also includes steps or units that are not listed, or optionally also includes other steps or units inherent to those processes, methods, products, or devices.

The present disclosure proposes a wearable electronic device. The wearable electronic device includes a movement assembly. The wearable electronic device includes earphones, eyeglasses, an augmented reality (AR) device, or a virtual reality (VR) device. The following describes an exemplary structure of the wearable electronic device through a practical application of the wearable electronic device of the present disclosure in earphones.

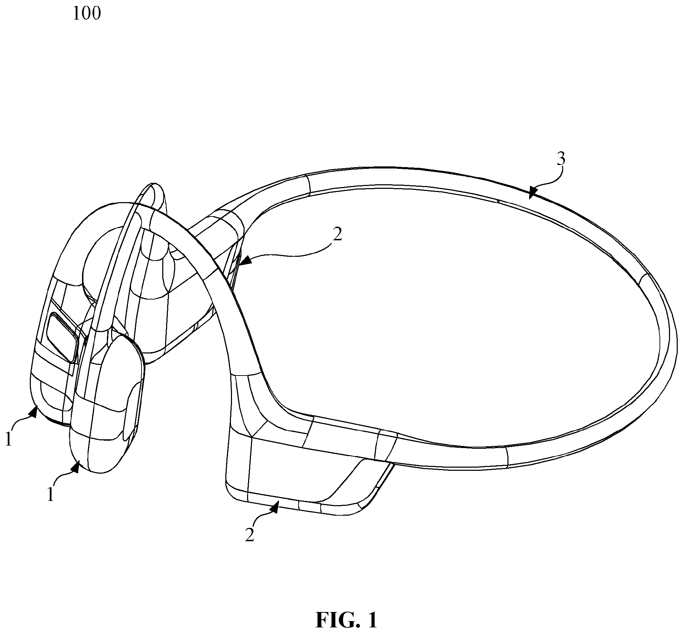

As shown in FIG. 1, the earphone 100 may include loudspeaker assemblies 1, ear-hook assemblies 2, and a rear-hook assembly 3. There may be two loudspeaker assemblies 1. The two loudspeaker assemblies 1 are configured to transmit vibration and/or sound to the user's left ear and right ear, respectively. The two loudspeaker assemblies 1 may be the same or different. For example, one loudspeaker assembly 1 may be provided with a microphone, and the other loudspeaker assembly 1 may not be provided with a microphone. As another example, one loudspeaker assembly 1 may be provided with a key and a corresponding circuit board, and another loudspeaker assembly 1 may not be provided with the key and the corresponding circuit board. The two loudspeaker assemblies 1 may be of the same configuration in terms of movement modules (e.g., loudspeaker modules). The loudspeaker assembly 1 described hereinafter may be considered to be described in detail by taking one of the two loudspeaker assemblies 1 as an example. There may be two ear-hook assemblies 2, and the two ear-hook assemblies 2 may be located in the user's left and right ears, respectively, so that the loudspeaker assemblies 1 can fit the user's face. For example, one of the ear-hook assemblies 2 may be provided with a battery, and another ear-hook assembly 2 may be provided with a control circuit, or the like. One end of an ear-hook assembly 2 is connected to a loudspeaker assembly 1, and another end of the ear-hook assembly 2 is connected to the rear-hook assembly 3. The rear-hook assembly 3 connects the two ear-hook assemblies 2, and the rear-hook assembly 3 is configured to be wrapped around the back of the user's neck or the back of the user's brain and provides a clamping force, which allows the two loudspeaker assemblies 1 to be clamped to both sides of the user's face or firmly arranged on the outside of the user's ears and allows the ear-hook assembly 2 to be more securely hang on the user's ears. It should be understood that the earphone 100 may not include the rear-hook assembly 3, with the loudspeaker assemblies 1 being worn in the user's ears through the ear-hook assemblies 2. Alternatively, the earphone 100 may not include the rear-hook assembly 3 and the ear-hook assemblies 2, and the loudspeaker assemblies 1 are connected by a headband structure or a neck-hook structure, the loudspeaker assemblies 1 are attached to the user's ears or securely disposed on the outside of the user's ears through the headband structure or the neck-hook structure.

The following primarily provides an exemplary description of a loudspeaker assembly 1 of the earphone 100. In some embodiments, the loudspeaker assembly 1 may also be referred to as a movement assembly.

Optionally, as shown in FIG. 1, FIG. 2, FIG. 3, FIG. 4, and FIG. 5, the loudspeaker assembly 1 includes a shell assembly 10, a bone-conducting loudspeaker 11, and an air-conducting loudspeaker 12.

The shell assembly 10 is provided with a first accommodation cavity 1001 and a second accommodation cavity 1002. The bone-conducting loudspeaker 11 is accommodated in the first accommodation cavity 1001, and the air-conducting loudspeaker 12 is accommodated in the second accommodation cavity 1002. The air-conducting loudspeaker 12 includes a magnetic circuit system 1260. The magnetic circuit system 1260 includes a magnet 1210 and a magnetic conduction assembly 1220. The magnet 1210 is fixed to the magnetic conduction assembly 1220, the magnetic conduction assembly 1220 is fixed in the second accommodation cavity 1002, and the magnetic conduction assembly 1220 is provided with a weight reduction structure 1223.

Specifically, in one embodiment, the bone-conducting loudspeaker 11 and the air-conducting loudspeaker 12 are simultaneously provided in the same shell assembly 10, and the bone-conducting loudspeaker 11 drives the loudspeaker assembly 1 to vibrate as a whole when it is in operation to transmit the sound to the user's ear. The air-conducting loudspeaker 12 includes the magnetic circuit system 1260. The magnetic circuit system 1260 includes the magnet 1210 and the magnetic conduction assembly 1220. Further, the magnetic conduction assembly 1220 is provided with the weight reduction structure 1223. The weight reduction structure 1223 is configured to reduce the overall weight of the air-conducting loudspeaker 12, thereby effectively reducing the overall weight of the loudspeaker assembly 1, improving the user experience, and effectively enhancing the operational stability of the bone-conducting loudspeaker 11. Moreover, as the bone-conducting loudspeaker 11 needs to drive the overall vibration of the loudspeaker assembly 1 to transmit sound to the user's ear when the bone-conducting loudspeaker 11 is working, decreasing the overall weight of the loudspeaker assembly 1 can improve the sensitivity of the bone-conducting loudspeaker 11, thereby effectively improving the sound transmission quality of the bone-conducting loudspeaker 11 and effectively improving the sound quality of the earphone.

Optionally, the weight reduction structure 1223 includes at least one of a groove or a through hole arranged at the magnetic conduction assembly 1220. In some embodiments, a through hole or a groove may be arranged at the magnetic conduction assembly 1220 to serve as the weight reduction structure 1223 of the magnetic conduction assembly 1220, or both a through hole and a groove may be arranged at the magnetic conduction assembly 1220 to serve as the weight reduction structure 1223 of the magnetic conduction assembly 1220. For example, in one embodiment, the weight reduction structure 1223 is realized by arranging a through hole at the magnetic conduction assembly 1220, which effectively reduces the overall weight of the loudspeaker assembly 1.

Optionally, a magnetic induction intensity at a position of the magnetic conduction assembly 1220 where the weight reduction structure 1223 is arranged is less than a magnetic induction intensity at other positions of the magnetic conduction assembly 1220. By arranging the groove and/or the through hole at a position of the magnetic conduction assembly 1220 where the magnetic induction intensity is smaller, it is possible to minimize the influence of arranging the groove or the through hole at the magnetic conduction assembly 1220 on the magnetic conduction function of the magnetic conduction assembly 1220, and ensure that the overall weight of the loudspeaker assembly 1 can be effectively reduced while affecting the magnetic conduction function of the magnetic conduction assembly 1220 as little as possible.

Optionally, the magnetic conduction assembly 1220 includes a magnetic conduction shield 1221 and a magnetic conduction plate 1222. The magnet 1210 is fixed in the magnetic conduction shield 1221, and the magnetic conduction plate 1222 is fixed to the magnet 1210. The weight reduction structure 1223 is arranged on at least one of the magnetic conduction shield 1221 or the magnetic conduction plate 1222, and there may be one or more weight reduction structures 1223 on the magnetic conduction shield 1221 and the magnetic conduction plate 1222. When a plurality of weight reduction structures 1223 are employed, the plurality of weight reduction structures 1223 are spaced apart.

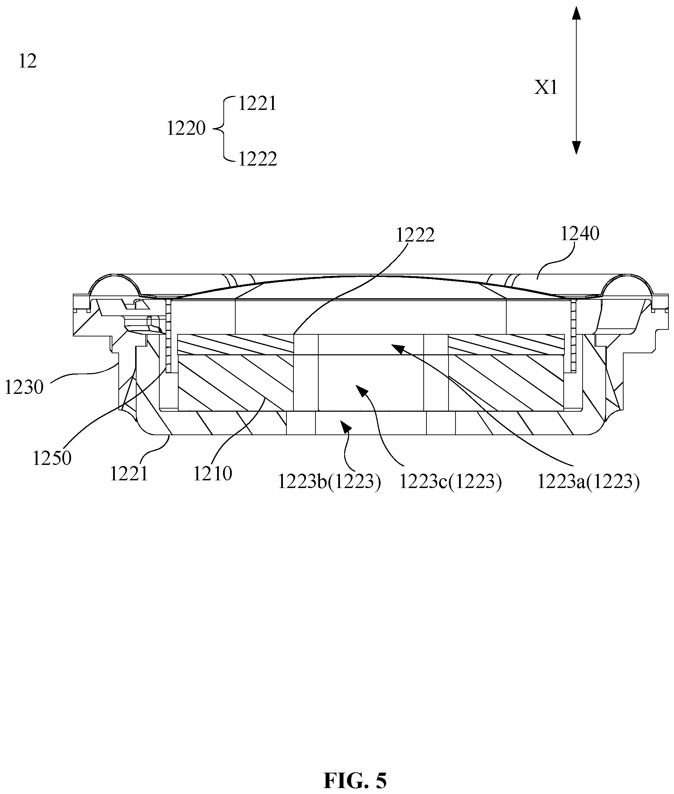

Specifically, the magnetic conduction shield 1221 is provided with a magnet accommodation slot for accommodating and fixing the magnet 1210. The magnet 1210 is fixed in the magnet accommodation slot, and the magnetic conduction plate 1222 is fixed to a side of the magnet 1210 away from the magnet accommodation slot. For example, referring to FIG. 5, in one embodiment, the magnetic conduction shield 1221 and the magnetic conduction plate 1222 are provided with one or more weight reduction structures 1223. In other embodiments, one or more weight reduction structures 1223 may be arranged on only the magnetic conduction plate 1222 or only magnetic conduction shield 1221. For example, in one embodiment, one weight reduction structure 1223 is arranged on the magnetic conduction shield 1221, and one weight reduction structure 1223 is correspondingly arranged on the magnetic conduction plate 1222. Based on this, the overall weight of the loudspeaker assembly 1 can be further reduced, thereby effectively enhancing the sound quality of the earphone.

Optionally, in one embodiment, the magnetic conduction shield 1221, the magnet 1210, and the magnetic conduction plate 1222 are sequentially centered along an air-conducting operating direction X1 of the air-conducting loudspeaker 12, which effectively ensures the centering of the center of mass of the magnetic conduction assembly 1220. The air-conducting operating direction X1 refers to a vibration direction of a vibration diaphragm of the air-conducting loudspeaker 12 during operation.

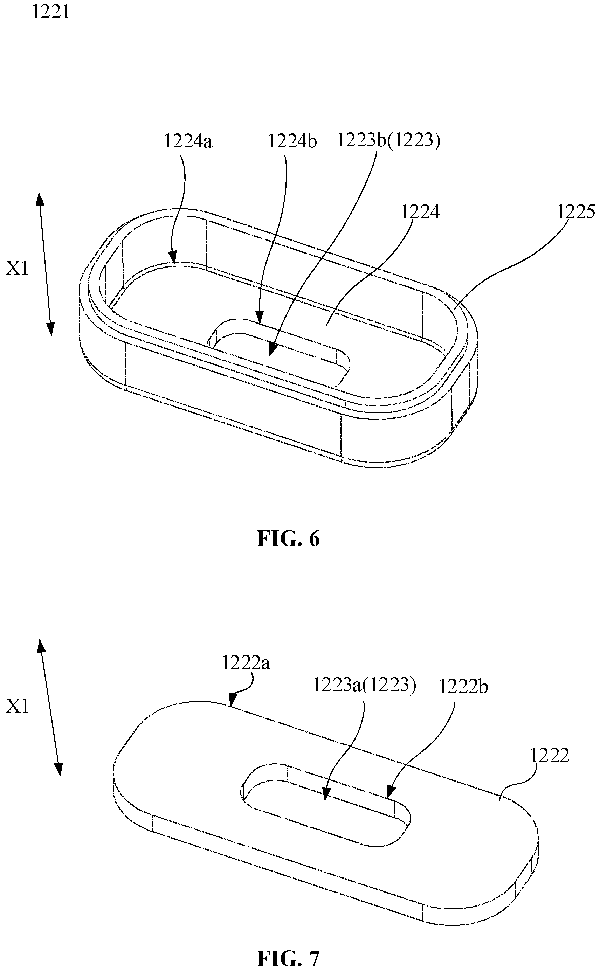

Optionally, as shown in FIG. 6, the magnetic conduction shield 1221 includes a bottom wall 1224 and an annular side wall 1225 extending from the bottom wall 1224, and a weight reduction structure 1223b is arranged at the bottom wall 1224. Specifically, referring to FIG. 6, in one embodiment, the magnetic conduction shield 1221 includes the bottom wall 1224 and the annular side wall 1225 extending from the bottom wall 1224. The bottom wall 1224 and the annular side wall 1225 enclose to form the magnet accommodation slot. Further, in one embodiment, the weight reduction structure 1223b is arranged at the bottom wall 1224. For example, a groove or a through hole, etc., is arranged at the bottom wall 1224. Based on this, the amount of material used for the bottom wall 1224 can be effectively reduced, which effectively reduces the weight of the magnetic conduction shield 1221 and reduces the weight of the air-conducting loudspeaker 12, thereby improving the operational stability of the bone-conducting loudspeaker 11 and improving the sound quality of the earphone.

Optionally, refer to FIG. 5 and FIG. 6, the weight reduction structure 1223b is centrally arranged at the bottom wall 1224. Specifically, the weight reduction structure 1223b on the magnetic conduction shield 1221 is centrally arranged at the bottom wall 1224 of the magnetic conduction shield 1221, and a magnetic induction intensity at the middle of the bottom wall 1224 of the magnetic conduction shield 1221 is smaller compared to other positions of the magnetic conduction shield 1221. Therefore, the weight reduction structure 1223b being centrally arranged at the bottom wall 1224 can effectively reduce the influence of the weight reduction structure 1223b on the magnetic conduction function of the magnetic conduction assembly 1220 and can effectively ensure that the center of mass of the magnetic conduction shield 1221 is centrally aligned, thereby effectively enhancing the operational stability of the bone-conducting loudspeaker 11 and enhancing the sound quality of the earphone.

It will be appreciated that in some other embodiments of the present disclosure, the weight reduction structure 1223b may also be arranged at other positions of the bottom wall 1224 of the magnetic conduction shield 1221.

Optionally, refer to FIG. 5 and FIG. 7, the weight reduction structure 1223a is centrally arranged at the magnetic conduction plate 1222. Specifically, the weight reduction structure 1223a is centrally arranged at the magnetic conduction plate 1222. The center of mass of components of the air-conducting loudspeaker 12 such as the magnetic conduction plate 1222, the magnetic conduction shield 1221, the magnet 1210 is centrally arranged and positioned at the same line along the air-conducting operating direction X1. Based on this, the center of mass of the air-conducting loudspeaker 12 can be ensured to be approximately located at the geometric center of the air-conducting loudspeaker 12. Centrally arranging the weight reduction structure 1223a can effectively prevent the weight reduction structure 1223a from affecting the center of mass of the magnetic conduction plate 1222 to cause a displacement of the center of mass of the air-conducting loudspeaker 12, thereby enhancing the operational stability of the bone-conducting loudspeaker 11 and improving the sound quality of the earphone. Moreover, a magnetic induction intensity at the middle of the magnetic conduction plate 1222 is smaller compared to a magnetic induction intensity at the other positions of the magnetic conduction plate, therefore, the weight reduction structure 1223a centrally arranging at the magnetic conduction plate 1222 can reduce the weight of the air-conducting loudspeaker 12 while reducing the influence of the weight reduction structure 1223a on the magnetic conduction function of the magnetic conduction assembly 1220.

Optionally, a total area of the weight reduction structure on the magnetic conduction shield 1221 accounts for less than or equal to a preset proportion of an area of the bottom wall 1224 of the magnetic conduction shield 1221; a total area of the weight reduction structure on the magnetic conduction plate 1222 accounts for less than or equal to a preset proportion of an area of the magnetic conduction plate 1222. Within the preset proportion, a magnetic induction intensity at a position where the weight reduction structure is located is smaller compared to other positions, thereby reducing the weight of the air-conducting loudspeaker 12 while reducing the influence of the weight reduction structure 1223a on the magnetic conduction function of the magnetic conduction assembly 1220.

Specifically, referring to FIG. 5, FIG. 6, and FIG. 7, in one embodiment, both the magnetic conduction plate 1222 and the magnetic conduction shield 1221 are arranged with a weight reduction structure. The area of the bottom wall 1224 of the magnetic conduction shield 1221 is an area enclosed by an outer rim contour 1224a of the bottom wall 1224, and the total area of the weight reduction structure 1223b on the magnetic conduction shield 1221 is an area of a region enclosed by an outer rim contour 1224b of the weight reduction structure 1223b. In one embodiment, the preset proportion is 50%. In other words, the total area of the weight reduction structure 1223b on the magnetic conduction shield 1221 accounts for less than or equal to 50% of the area of the bottom wall 1224 of the magnetic conduction shield 1221. Based on this, it can effectively reduce the weight of the magnetic conduction shield 1221 without affecting the magnetic conduction function of the magnetic conduction shield 1221. Similarly, the area of the magnetic conduction plate 1222 is an area enclosed by an outer rim contour 1222a of the magnetic conduction plate 1222, and the total area of the weight reduction structure 1223a on the magnetic conduction plate 1222 is the total area enclosed by an outer rim contour 1222b of the weight reduction structure. The total area of the weight reduction structure 1223a on the magnetic conduction plate 1222 accounts for less than or equal to 50% of the area of the magnetic conduction plate 1222. Based on this, it can efficiently reduce the weight of the magnetic conduction plate 1222 without affecting the magnetic conduction function of the magnetic conduction plate 1222. In some embodiments, if a plurality of weight reduction structures 1223b are arranged on the magnetic conduction shield 1221, the total area of the weight reduction structures 1223b on the magnetic conduction shield 1221 is the sum of the areas of the plurality of weight reduction structures 1223b. Similarly, if a plurality of weight reduction structures 1223a are arranged on the magnetic conduction plate 1222, the total area of the weight reduction structures on the magnetic conduction plate 1222 is the sum of the areas of the plurality of weight reduction structures 1223b.

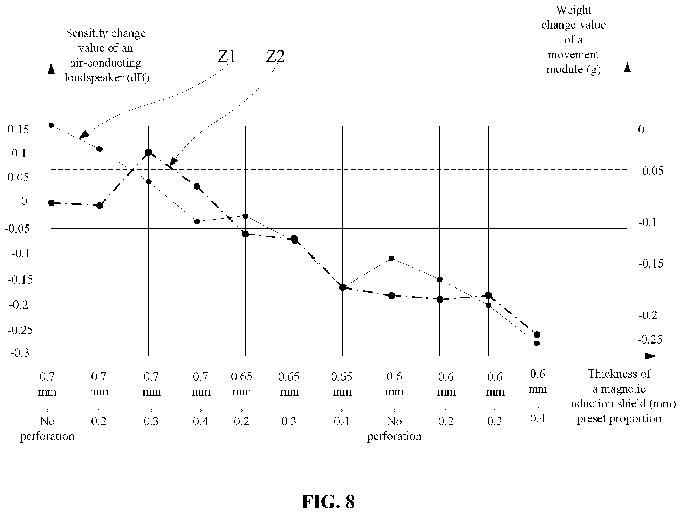

As shown in FIG. 8, taking the preset proportion of the total area of the weight reduction structure 1223b of the magnetic conduction shield 1221 to the total area of the bottom wall 1224 as an example, a simulation experiment was conducted to obtain a relationship curve Z2 between the preset proportion and a sensitivity change value of the air-conducting loudspeaker 12 and a relationship curve Z1 between the preset proportion and a weight change value of the loudspeaker assembly 1. Referring to the relationship curve Z1, the weight change value of the loudspeaker assembly 1 increases as the preset proportion increases and the thickness of the bottom wall 1224 reduces, i.e., the weight of the loudspeaker assembly 1 decreases as the preset proportion increases and the thickness of the bottom wall 1224 decreases. Referring to the relationship curve Z2, as the preset proportion increases, the sensitivity change value of the air-conducting loudspeaker 12 tends to increase slightly and then decrease when the thickness of the bottom wall 1224 is the same. Therefore, selecting a preset proportion of less than or equal to 50% can effectively ensure the weight reduction influence of the loudspeaker assembly 1 while reducing the influence of the weight reduction structure 1223b on the magnetic conduction function of the magnetic conduction shield 1221. Moreover, it can be seen that when the thickness of the bottom wall 1224 is the same, the preset proportion of less than or equal to 30% can reduce the weight of the loudspeaker assembly 1 with less influence on the magnetic conduction function of the magnetic conduction shield 1221. The magnetic conduction plate 1222 may also undergo similar simulation experiments to obtain the corresponding experimental data. It can be concluded that when the preset proportion is less than or equal to 30%, the loudspeaker assembly 1 can achieve a better weight reduction effect while minimizing the influence on the magnetic conduction function of the magnetic conduction plate 1222. The magnet 1210 hereinafter is similar, and will not be repeated herein in detail.

Optionally, in some embodiments, the preset proportion may also be 50% and greater than 0. For example, the preset proportion may be 45%, 40%, 35%, 28%, 20%, 10%, 5%, or the like. In other words, the total area of the weight reduction structure 1223b on the magnetic conduction shield 1221 accounts for less than or equal to 50% of the area of the bottom wall 1224 of the magnetic conduction shield 1221. Based on this, the weight of the magnetic conduction shield 1221 can be effectively reduced without affecting the magnetic conduction function of the magnetic conduction shield 1221. The total area of the weight reduction structure 1223a on the magnetic conduction plate 1222 accounting for less than 50% of the area of the magnetic conduction plate 1222 can effectively reduce the weight of the magnetic conduction plate 1222 without affecting the magnetic conduction function of the magnetic conduction plate 1222.

In some embodiments, only one of the magnetic conduction plate 1222 or the magnetic conduction shield 1221 is arranged with the weight reduction structure 1223. A proportion of the total area of the weight reduction structure 1223 to the area of the magnetic conduction plate 1222 or the bottom wall 1224 of the magnetic conduction shield 1221 can be seen referred to in the descriptions above, and will not be repeated herein in detail.

Optionally, referring to FIG. 6, a planar shape of the weight reduction structure 1223b is the same as a planar shape of the bottom wall 1224 of the magnetic conduction shield 1221 and is reduced in equal proportion relative to the planar shape of the bottom wall 1224 of the magnetic conduction shield 1221. Specifically, the planar shape of the weight reduction structure 1223b is the same as the planar shape of the bottom wall 1224 of the magnetic conduction shield 1221 and is reduced in equal proportion relative to the planar shape of the bottom wall 1224 of the magnetic conduction shield 1221, it may be understood that the planar shape of the weight reduction structure 1223b on the magnetic conduction shield 1221 perpendicular to the air-conducting operation direction X1 is the same as the planar shape of the bottom wall of the magnetic conduction shield 1221 perpendicular to the air-conducting operation direction X1, and is reduced in equal proportion relative to the planar shape of the bottom wall of the magnetic conduction shield 1221. Based on this, it can effectively ensure the alignment of the center of mass of the magnetic conduction shield 1221 and a center of the magnetic conduction shield 1221. It is to be understood that in other embodiments of the present disclosure, the planar shape of the weight reduction structure 1223b on the magnetic conduction shield 1221 perpendicular to the air-conducting operating direction X1 and the planar shape of the bottom wall of the magnetic conduction shield 1221 perpendicular to the air-conducting operating direction X1 may also be different.

Optionally, referring further to FIG. 7, the planar shape of the weight reduction structure 1223a on the magnetic conduction plate 1222 perpendicular to the air-conducting operating direction X1 is the same as the planar shape of the magnetic conduction plate 1222 perpendicular to the air-conducting operating direction X1, and is reduced in equal proportion relative to the planar shape of the magnetic conduction plate 1222. Based on this, it can effectively ensure the alignment of the center of mass of the magnetic conduction plate 1222 and a center of the magnetic conduction plate 1222. For example, in one embodiment, a weight reduction structure 1223b with a planar shape that is the same as the planar shape of the magnetic conduction shield 1221 and is reduced in equal proportion relative to the planar shape of the magnetic conduction shield 1221 is centrally arranged on the magnetic conduction shield 1221, and a weight reduction structure 1223b with a planar shape that is the same as the planar shape of the magnetic conduction plate 1222 and is reduced in equal proportion relative to the planar shape of the magnetic conduction plate 1222 is centrally arranged on the magnetic conduction plate 1222. Based on this, it can effectively ensure the alignment of the center of mass of the air-conducting loudspeaker 12 and a center of the air-conducting loudspeaker 12, and reduce the weight of the loudspeaker assembly 1, thereby effectively improving the sound quality of the earphone. It is to be understood that, in other embodiments of the present disclosure, the planar shape of the weight reduction structure 1223a on the magnetic conduction plate 1222 perpendicular to the air-conducting operating direction X1 and the planar shape of the magnetic conduction plate 1222 perpendicular to the air-conducting operating direction X1 may also be different.

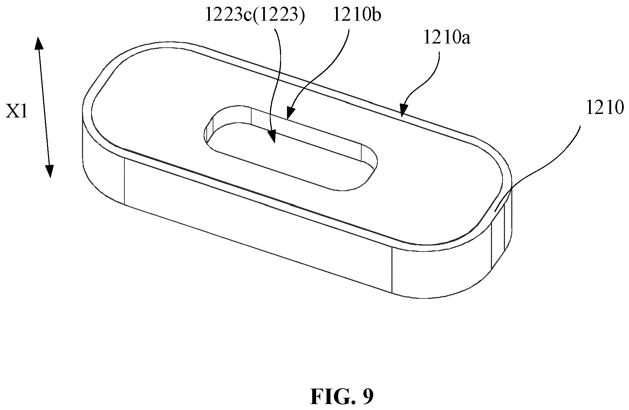

Optionally, referring to FIG. 5 and FIG. 9, the magnet 1210 may be arranged with a weight reduction structure 1223c, and the weight reduction structure 1223c is a groove or a through hole. In one embodiment, the weight reduction structure 1223c is a through hole. Based on this, the weight of the loudspeaker assembly 1 can be further reduced, thereby effectively enhancing the sound quality of the earphone.

Optionally, a magnetic induction intensity at a position of the magnet 1210 where the weight reduction structure 1223c is arranged is less than a magnetic induction intensity at other positions of the magnet 1210. Specifically, the magnetic induction intensity at the position of the magnet 1210 where the weight reduction structure 1223c is arranged is less than a magnetic induction intensity at other positions of the magnet 1210. This setting can effectively reduce the overall weight of the loudspeaker assembly 1 without affecting the magnetic conduction function of the magnetic conduction assembly 1220.

Optionally, referring further to FIG. 5 and FIG. 9, the weight reduction structure 1223c on the magnet 1210 is located at a center of the magnet 1210, and a planar shape of the weight reduction structure 1223c on the magnet 1210 is the same as a planar shape of the magnet 1210 and is reduced in equal proportion relative to the planar shape of the magnet 1210. Specifically, the planar shape of the weight reduction structure 1223c on the magnet 1210 is the same as the planar shape of the magnet 1210 and is reduced in equal proportion relative to the planar shape of the magnet 1210, and it may be understood that the planar shape of the weight reduction structure 1223c on the magnet 1210 perpendicular to the air-conducting operating direction X1 is the same as the planar shape of the magnet 1210 perpendicular to the air-conducting operating direction X1 and is reduced in equal proportion relative to the planar shape of the magnet 1210. The weight reduction structure 1223c is arranged on the magnet 1210 based on the above-described manner, which can effectively ensure the alignment of the center of mass of the air-conducting loudspeaker 12 and a center of the air-conducting loudspeaker 12 while effectively reducing the weight of the loudspeaker assembly 1, thus effectively enhancing the sound quality of the earphone.

Optionally, a planar area of the weight reduction structure 1223c on the magnet 1210 is less than a preset proportion of the planar area of the magnet 1210. In one embodiment, the preset proportion is 50%, and in other embodiments, the preset proportion may be other values. The planar area of the weight reduction structure 1223c is an area enclosed by an outer rim contour 1210b of the weight reduction structure 1223c, and the planar area of the magnet 1210 is an area enclosed by an outer rim contour 1210a of the magnet 1210. Based on this, it can effectively reduce the weight of the magnet 1210 without affecting the magnetic conduction function of the magnet 1210.

Optionally, the weight reduction structure 1223 does not need to be filled with other materials, such as a plastic member, that is, the weight reduction structure 1223 remains in a hollow state. In this way, the weight reduction effect can be fully achieved.

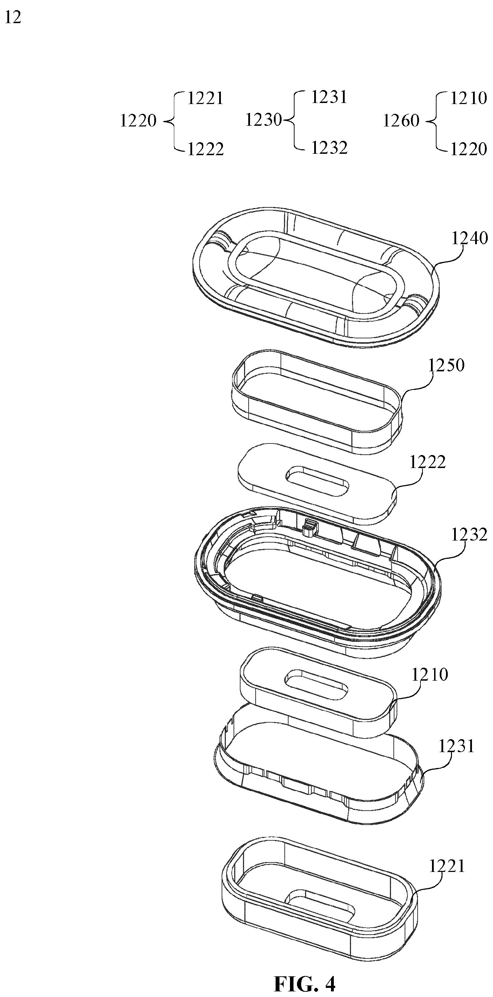

Optionally, referring to FIG. 4 and FIG. 5, the air-conducting loudspeaker 12 further includes a fixing assembly 1230. The fixing assembly 1230 is fixed to the magnetic conduction assembly 1220 and is fixedly connected to the shell assembly 10. The magnetic conduction assembly 1220 arranged with the magnet 1210 is fixedly connected to the shell assembly 10 through the fixing assembly 1230, which facilitates fixation of the magnetic conduction assembly 1220 in the shell assembly 10, enhances the connection stability of the magnetic conduction assembly 1220 and the shell assembly 10, and reduces the jitter of the magnetic conduction assembly 1220 relative to the shell assembly 10, thereby effectively improve the operational stability of the air-conducting loudspeaker 12 and improving the sound quality of the earphone.

Optionally, referring to FIG. 4 and FIG. 5, the air-conducting loudspeaker 12 further includes a vibration diaphragm 1240 and a voice coil 1250, with a rim of the vibration diaphragm 1240 being fixed to a periphery of the fixing assembly 1230, and the voice coil 1250 being fixed to the vibration diaphragm 1240. Specifically, in one embodiment, the voice coil 1250 is around an outer peripheral side of the magnet 1210 and the magnetic conduction plate 1222, the rim of the vibration diaphragm 1240 is connected to the periphery of the fixing assembly 1230, and the voice coil 1250 is connected to the vibration diaphragm 1240. For example, as shown in FIG. 4 and FIG. 5, in one embodiment, the fixing assembly 1230 includes a fixing ring 1231 and a fixing body 1232. The fixing ring 1231 is fitted onto an outer circumference of the annular side wall 1225 of the magnetic conduction shield 1221 and is located between an inner sidewall of the fixing body 1232 and the outer circumference of the annular side wall 1225. Based on this, the fixing ring 1231 is configured to provide a tension force. The rim of the vibration diaphragm 1240 is connected to the periphery of the fixing body 1232. When assembling the fixing assembly 1230 and the magnetic conduction shield 1221, after the fixing ring 1231 is fitted onto the outer circumference of the annular side wall 1225 of the magnetic conduction shield 1221, the magnetic conduction shield 1221 fitted with the fixing ring 1231 may be pushed into an inner circumference of the fixing body 1232 along the air-conducting operating direction X1, which quickly fixes the magnetic conduction shield 1221 to the fixing assembly 1230, thereby enabling the magnetic conduction shield 1221 to maintain a stable and fixed connection with the fixing body 1232 while effectively improving the assembly efficiency of the air-conducting loudspeaker 12.

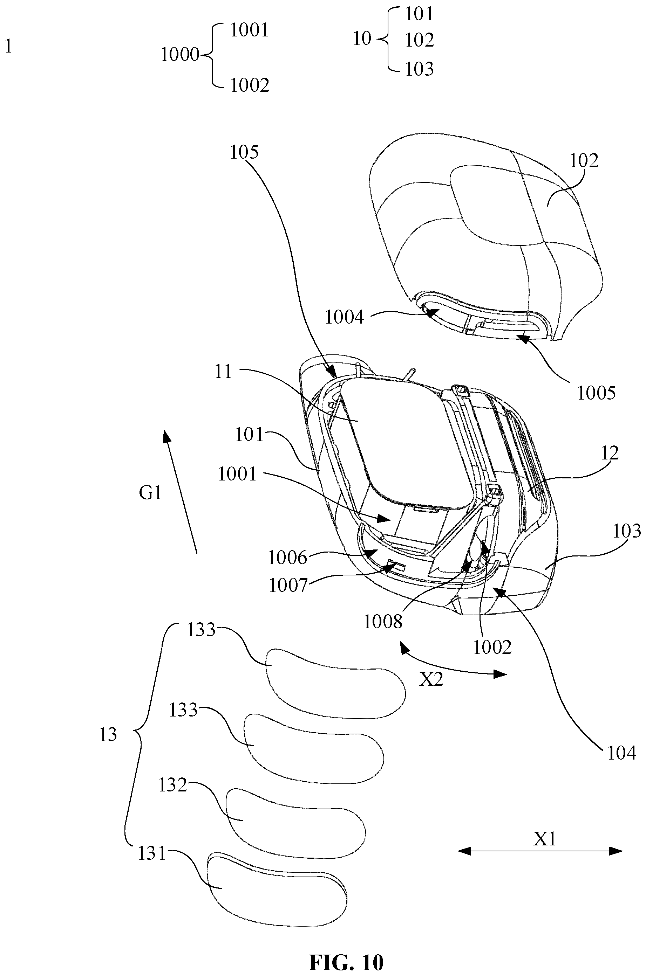

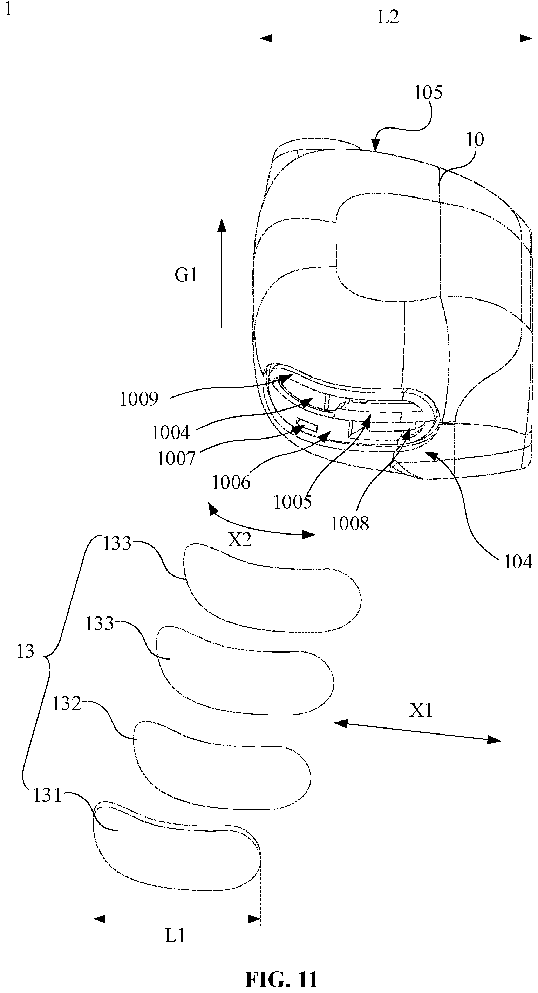

Optionally, referring to FIG. 10 and FIG. 11, the shell assembly 10 is provided with a pressure relief hole 1008 for communicating the second accommodation cavity 1002 and the external environment, and the pressure relief hole 1008 extends toward a side where the first accommodation cavity 1001 is located. The shell assembly 10 is provided with the pressure relief hole 1008 for relieving pressure for the air-conducting loudspeaker 12, the pressure relief hole 1008 communicates with the second accommodation cavity 1002 and the external environment, and the pressure relief hole 1008 extends toward the side where the first accommodation cavity 1001 is located from the communication position between the second accommodation cavity 1002 and the pressure relief hole 1008. For example, a portion of a hole wall of the pressure relief hole 1008 extends from the communication position of the second accommodation cavity 1002 and the pressure relief hole 1008 toward the side where the first accommodation cavity 1001 is located, which can effectively reduce the occupation of the outer shell space of the first accommodation cavity 1001 by the pressure relief hole 1008 while efficiently utilizing the space between the first accommodation cavity 1001 and the second accommodation cavity 1002 and enhancing the spatial utilization of the shell assembly 10, allowing for a more compact and reasonable design of the shell assembly 10 while still meeting the acoustic requirements of the air-conducting loudspeaker 12. Besides, such an inclined extension can increase the dimension of the pressure relief hole 1008, which makes it possible to provide the air-conducting loudspeaker 12 with better sound quality.

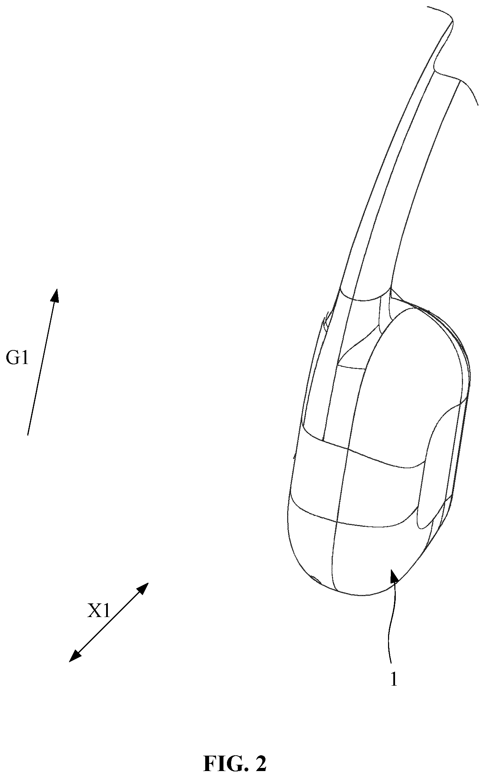

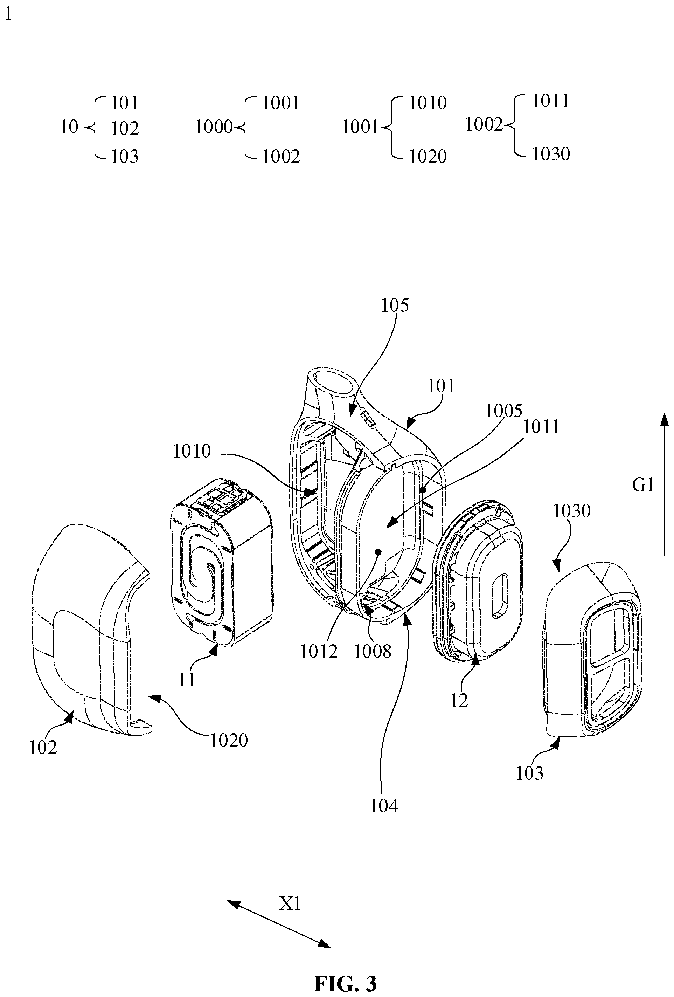

Optionally, referring to FIG. 2 and FIG. 3, the shell assembly 10 may include a shell 101, a shell 102, and a shell 103. The shell 101 and the shell 102 fit with each other to form the first accommodation cavity 1001. The shell 101 and/or the shell 102 may form a portion of the second accommodation cavity 1002, and the shell 103 may form the other portion of the second accommodation cavity 1002, so that the shell 103 and the shell 101 and/or the shell 102 fits with each other to form the second accommodation cavity 1002.

The shell assembly 10 may be composed of the shell 101, the shell 102, and the shell 103 fitting with each other. The shell 101 and the shell 102 fit with each other to form the first accommodation cavity 1001, and the shell 103 and the shell 101 fit with each other to form the second accommodation cavity 1002. The shell 101, the shell 102, and the shell 103 fitting with each other to form the shell assembly 10 can make the structure of the loudspeaker assembly 1 compact while facilitating the assembly of the loudspeaker assembly 1, to enhance the assembly efficiency of the loudspeaker assembly 1. In some embodiments, the shell 101 may be referred to as a first shell; the shell 102 may be referred to as a second shell; and the shell 103 may be referred to as a third shell.

The shell assembly 10 may include the shell 101, the shell 102, and the shell 103. A partition wall 1012 may be disposed on the shell 101 and/or the shell 102, the shell 101 and the shell 102 fitting with each other to form the first accommodation cavity 1001 and the pressure relief hole 1008. For example, the shell 101 and/or the shell 102 further form a portion of the second accommodation cavity 1002. For example, the shell 103 may form the other portion of the second accommodation cavity 1002, with the shell 103 fitting with the shell 101 and/or the shell 102 to form the second accommodation cavity 1002. Disposing the partition wall 1012 to the shell 101 and/or the shell 102 may be understood as the partition wall 1012 is a part of the shell 101 and/or the shell 102. It should be understood that how the partition wall 1012 is disposed is not limited to being disposed on the shell 101 and/or the shell 102. In other embodiments, the partition wall 1012 may be a component that is independent of the shell 101 and/or the shell 102.

As shown in FIG. 3, the partition wall 1012 is disposed on the shell 101, and the shell 101 includes a sub-accommodation cavity 1010 and a sub-accommodation cavity 1011 located on two opposite sides of the partition wall 1012, and an opening direction of the sub-accommodation cavity 1010 is along a wall surface of the partition wall 1012. Specifically, the opening direction of the sub-accommodation cavity 1010 is parallel or substantially parallel to the wall surface of the partition wall 1012. The opening direction of the sub-accommodation cavity 1011 is configured as to intersect with the wall surface of the partition wall 1012. The shell 102 is provided with a sub-accommodation cavity 1020, the shell 102 is capped at an opening end of the sub-accommodation cavity 1010, and the sub-accommodation cavity 1020 and the sub-accommodation cavity 1010 fit with each other to form the sub-accommodation cavity 1010. The shell 103 is provided with a sub-accommodation cavity 1030, the shell 103 is capped at an opening end of the sub-accommodation cavity 1011, and the sub-accommodation cavity 1030 fits with the sub-accommodation cavity 1011 to form the second accommodation cavity 1002. In some embodiments, the sub-accommodation cavity 1010 may also be referred to as a first sub-accommodation cavity; the sub-accommodation cavity 1011 may also be referred to as a second sub-accommodation cavity; the sub-accommodation cavity 1020 may also be referred to as a third sub-accommodation cavity; the sub-accommodation cavity 1030 may also be referred to as a fourth sub-accommodation cavity.

By disposing the partition wall 1012, the shell 101 is divided into the sub-accommodation cavity 1010 whose opening direction is along the wall surface of the partition wall 1012 and the sub-accommodation cavity 1011 whose opening direction intersects with crosswise with the wall surface of the partition wall 1012, so that a large space can be realized for both the sub-accommodation cavity 1010 and the sub-accommodation cavity 1011, improving the space utilization rate of the shell 101 and reducing the mutual interference between the bone-conducting loudspeaker 11 and the air-conducting loudspeaker 12 vibrating with each other in operation, thereby improving the sound quality.

Optionally, as shown in FIG. 3, FIG. 10, FIG. 11, and FIG. 12, the present disclosure also proposes a first embodiment of a pressure relief hole 1008 protection scheme for protecting the pressure relief hole 1008. The first embodiment of the pressure relief hole 1008 protection scheme is applicable to the earphone provided with both the bone-conducting loudspeaker 11 and the air-conducting loudspeaker 12, and may also be applicable to the earphone 100 provided with the air-conducting loudspeaker 12 alone. Herein, the first embodiment of the pressure relief hole 1008 protection scheme is described in terms of the earphone 100 provided with both the air-conducting loudspeaker 12 and the bone-conducting loudspeaker 11. The first embodiment of the pressure relief hole 1008 protection scheme is described as follows.

The loudspeaker assembly 1 includes a protective mesh 13. The shell assembly 10 is provided with an accommodation cavity and the pressure relief hole 1008 for communicating the accommodation cavity and the external environment. An opening mouth of the pressure relief hole 1008 is located at a bottom 104 of the shell assembly 10 along a height direction G1. The loudspeaker is accommodated in the accommodation cavity, and the protective mesh 13 is connected to the shell assembly 10 and covers the opening mouth of the pressure relief hole 1008. A projection is carried out along the height direction G1, and a length L1 of a projection of the protective mesh 13 is more than 0.4 times a length L2 of a projection of the shell assembly 10.

Specifically, as shown in FIG. 3 and FIG. 10, the accommodation cavity is configured to accommodate the loudspeaker, and the accommodation cavity includes the first accommodation cavity 1001 and a second accommodation cavity 1002 spaced apart. The loudspeaker includes the air-conducting loudspeaker 12 and the bone-conducting loudspeaker 11, with the air-conducting loudspeaker 12 being accommodated in the second accommodation cavity 1002, and the bone-conducting loudspeaker 11 being accommodated in the first accommodation cavity 1001. The specific structure of the shell assembly 10 is described in the content set forth herein and will not be repeated herein in detail. In other embodiments, the accommodation cavity of the earphone 100 may be provided with only the air-conducting loudspeaker 12, which will not be described in detail herein.

As shown in FIG. 10 and FIG. 11, the shell assembly 10 is provided with the pressure relief hole 1008 of the air-conducting loudspeaker 12 for pressure relief. The pressure relief hole 1008 is in communication with the accommodation cavity and the external environment, and it can be understood that the pressure relief hole 1008 communicates with the external environment and the second accommodation cavity 1002 for accommodating the air-conducting loudspeaker 12. Other relative positional relationships between the pressure relief hole 1008 and the accommodation cavity are described above and will not be repeated herein in detail.

Further, the pressure relief hole 1008 is located at the bottom 104 of the shell assembly 10 along the height direction G1. When the earphone 100 is in a wearing state, the height direction G1 may be approximately parallel to the direction of gravity, and the bottom 104 of the shell assembly 10 is positioned downward along the height direction G1 or the direction of gravity. Based on this, the opening of the pressure relief hole 1008 being located at the bottom 104 of the shell assembly 10 along the height direction G1 effectively prevents external adverse factors such as sweat and rain from entering the accommodation cavity through the opening of the pressure relief hole 1008, which effectively prevents damage to the loudspeaker (specifically, the air-conducting loudspeaker 12 in this embodiment) caused by sweat, rain, and other external adverse factors, thereby significantly enhancing the operational stability of the earphone 100. Furthermore, the earphone 100 further includes the protective mesh 13 for providing a barrier against external adverse factors such as sweat, rain, and sand. The protective mesh 13 is connected to the shell assembly 10 and covers the opening of the pressure relief hole 1008. Along a height direction G1, the length L1 of the projection of the protective mesh 13 is more than 0.4 times the length L2 of the projection of the shell assembly 10. The length L1 of the projection is a length of the protective mesh 13 along the air-conducting operating direction X1. The length L1 of the projection of the protective mesh 13 may be within a range of 0.4 to 1 times the length L2 of the projection of the shell assembly 10, e.g., 0.4 times, 0.45 times, 0.5 times, 0.55 times, 0.6 times, 0.7 times, 0.8 times, 0.9 times, 1 times, etc. Based on this, the overall dimension and area of the protective mesh 13 can be effectively enhanced, reduces the risk of sweat, rain, and other external adverse factors forming a water film at the protective mesh 13 and blocking the pressure relief hole 1008, and then effectively ensures that the pressure relief hole 1008 can operate normally, and thus effectively enhances the operational stability of the earphone 100. It should be understood that since the protective mesh 13 may be curved in shape, an actual length of the protective mesh 13 may be greater than the length L1 of the projection of the protective mesh 13. The height direction G1 is a direction along the bottom 104 of the shell assembly 10 to a top 105 of the shell assembly 10, as follows.

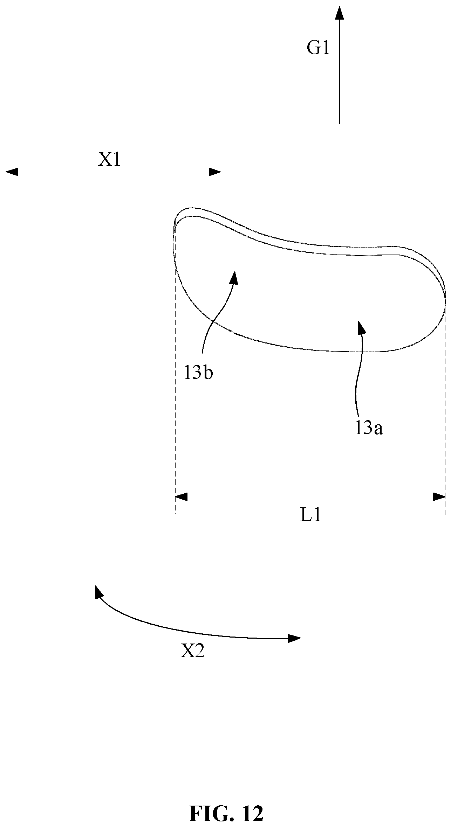

Optionally, as shown in FIG. 12, the protective mesh 13 includes a first portion 13a that is low along the height direction G1 and a second portion 13b that extends from the first portion 13a. Along the height direction G1, as the second portion 13b gradually extends away from the first portion 13a, the second portion 13b is gradually higher than the first portion 13a. In this manner, the protective mesh 13 may be configured as a curved shape, which may be adapted to the shape of the shell assembly 10.

Specifically, the protective mesh 13 includes the first portion 13a that is low along the height direction G1 and the second portion 13b that extends from the first portion 13a, and as the second portion 13b gradually extends away from the first portion 13a, the second portion 13b is gradually higher than the first portion 13a along the height direction G1. Based on this, the protective mesh 13 is configured as a curved shape, which allows sweat, rain, and other external adverse factors flowing through the second portion 13b to ultimately drip or slide down to the first portion 13a before falling off. This effectively prevents the accumulation of sweat, rain, and other external elements in the second portion 13b, which could otherwise cause clogging. Additionally, positioning the second portion 13b higher than the first portion 13a increases the kinetic energy of the sweat, rain, and other external elements, further preventing their accumulation on the protective mesh 13 and avoiding blockage of the pressure relief hole 1008, thereby enhancing the operational stability of the earphone 100.

Optionally, referring further to FIG. 10 and FIG. 11, the shell assembly 10 is provided with a first recessed portion 1004. The first recessed portion 1004 is in communication with the pressure relief hole 1008, and the protective mesh 13 covers the opening of the first recessed portion 1004. Specifically, the shell assembly 10 is provided with the first recessed portion 1004, and the first recessed portion 1004 is in communication with the pressure relief hole 1008. The air-conducting operating direction X1 is a vibration direction of the air-conducting loudspeaker 12 when it operates, the air-conducting operating direction X1 is substantially perpendicular to the height direction G1. Based on this, the first recessed portion 1004 may be used as an auxiliary pressure relief hole of the air-conducting loudspeaker 12, which can effectively increase the pressure relief area of the pressure relief hole, and when the pressure relief hole 1008 is blocked, the pressure of the air-conducting loudspeaker 12 can continue to be relieved through the first recessed portion 1004, thereby effectively reducing the probability and extent of low-frequency sound loss of the earphone 100, thereby effectively improving the operational stability of the earphone 100.

Optimally, the first recessed portion 1004 extends from the pressure relief hole 1008. As the first recessed portion 1004 gradually extends away from the pressure relief hole 1008, the first recessed portion 1004 is gradually higher than the opening of the pressure relief hole 1008 along the height direction G1. Specifically, the first recessed portion 1004 is located on a side of the pressure relief hole 1008 along an arrangement direction X2 that is parallel to the air-conducting operating direction X1 and perpendicular to the height direction G1, and the first recessed portion 1004 extends from the pressure relief hole 1008. As the first recessed portion 1004 gradually extends away from the pressure relief hole 1008, the first recessed portion 1004 is gradually higher than the opening of the pressure relief hole 1008. Based on this, the first recessed portion 1004 can be effectively prevented from being clogged or immersed by external factors such as sweat or rain, thereby effectively enhancing the operational stability of the air-conducting loudspeaker 12.

Optionally, referring to FIG. 10, FIG. 11, and FIG. 12, the protective mesh 13 includes the first portion 13a that is low along the height direction G1 and the second portion 13b that extends from the first portion 13a. As the second portion 13b gradually extends away from the first portion 13a, the second portion 13b is gradually higher than the first portion 13a along the height direction G1. The second portion 13b covers at least a portion of the opening of the first recessed portion 1004. Specifically, the protective mesh 13 is configured as a curved shape based on the above-described manner. The second portion 13b covers at least a portion of the opening of the first recessed portion 1004. For example, in one embodiment, the first portion 13a covers a portion of the opening of the first recessed portion 1004, the second portion 13b covers the other portion of the opening of the first recessed portion 1004. Based on this, fully covering the first recessed portion 1004 and the pressure relief hole 1008 with the protective mesh 13 can effectively prevent sweat, rain, and other external factors from clogging the pressure relief hole 1008 and the first recessed portion 1004. Such an arrangement also effectively prevents other external particulate contaminants from entering the second accommodation cavity through the pressure relief hole 1008 and the first recessed portion 1004, which could otherwise damage the air-conducting loudspeaker 12, thereby effectively enhancing the operational stability of the earphone 100. The protective mesh 13 is configured as a curved shape based on the above-described manner, allowing sweat, rain, and other external contaminants flowing through the second portion 13b to ultimately drip or slide down to the first portion 13a before falling off. Such an arrangement effectively prevents the accumulation and crystallization of sweat, rain, and other external contaminants in the second portion 13b. Additionally, positioning the second portion 13b higher than the first portion 13a increases the kinetic energy of the sweat, rain, and other external contaminants, further preventing their accumulation on the protective mesh 13, which could otherwise clog the pressure relief hole 1008, thereby effectively enhancing the operational stability of the earphone 100.

Optionally, as shown in FIG. 10 and FIG. 11, the shell assembly 10 includes a support member 1005, the support member 1005 separating the opening of the pressure relief hole 1008 from the opening of the first recessed portion 1004, and the support member 1005 is configured to support the protective mesh 13. Specifically, the support member 1005 is disposed between the pressure relief hole 1008 and the first recessed portion 1004, and abuts against a centered region of the protective mesh 13, which can effectively prevent the protective mesh 13 from collapsing due to its large area, thereby ensuring that the protective mesh 13 can function normally and stably, and thereby effectively improving the operational stability of the earphone 100. Optionally, in some embodiments, the support member 1005 may be integrally molded with the shell assembly 10. In other embodiments, the support member 1005 may be a separate component that is connected to the shell assembly 10 by a connecting member such as a dispensing adhesive.

Optionally, as shown in FIG. 10 and FIG. 11, the shell assembly 10 is provided with a sound receiving hole 1007, the sound receiving hole 1007 is disposed adjacent to the opening of the pressure relief hole 1008, and the protective mesh 13 also covers the sound receiving hole 1007. Specifically, the sound receiving hole 1007 of the earphone 100 that is configured to receive sound information (e.g., the user's voice enters the microphone of the earphone 100 via the sound receiving hole 1007) is disposed adjacent to the pressure relief hole 1008, and the protective mesh 13 also covers the sound receiving hole 1007. The protective mesh 13 effectively protects the sound receiving hole 1007 from erosion by sweat, rain, and other external adverse factors. Along the height direction G1, the length L1 of the projection of the protective mesh 13 is more than 0.4 times the length L2 of the projection of the shell assembly 10. Based on this, it can be ensured that the length of the protective mesh 13 is long enough so that the sound receiving hole 1007 and the pressure relief hole 1008 are staggered from each other as much as possible, thereby effectively ensuring the sound quality of the earphone 100.

Optionally, as shown in FIG. 10 and FIG. 11, the opening of the sound receiving hole 1007 is higher than the opening of the pressure relief hole 1008 along the height direction G1. By setting the sound receiving hole 1007 higher than the bottom of the shell assembly 10 along the height direction G1, the sound receiving hole 1007 can be effectively prevented from being eroded by sweat, rain, and other undesirable external factors.

Optionally, an area of the protective mesh 13 is more than 1.5 times an area of the opening of the pressure relief hole 1008. For example, the area of the protective mesh 13 may be more than 1.5 times, 1.8 times, 2 times, 2.5 times, 3 times, 4 times, 5 times, 6 times, 7 times, 8 times, 9 times, 10 times, etc., the area of the opening of the pressure relief hole 1008. Based on this, it can ensure that the area of the protective mesh 13 is sufficiently large, thereby reducing the risk of sweat, rain, and other external contaminants forming a water film on the protective mesh 13 and blocking the pressure relief hole 1008, which ensures that the pressure relief hole 1008 can function properly, thereby significantly enhancing the operational stability of the earphone 100. Further, based on the above setting, the area of the protective mesh 13 is set to be sufficiently large relative to the pressure relief hole 1008, thereby providing more effective protection for the first recessed portion 1004, the sound receiving hole 1007, and the pressure relief hole 1008 together, improving the protection efficiency. At the same time, placing multiple structures such as the first recessed portion 1004, the sound receiving hole 1007, and the pressure relief hole 1008 at the bottom 104 of the shell assembly 10 allows for full utilization of the structural space of the shell assembly 10.

Optionally, as shown in FIG. 10 and FIG. 11, the protective mesh 13 includes the first portion 13a that is low along the height direction G1 and the second portion 13b that extends from the first portion 13a. As the second portion 13b gradually extends away from the first portion 13a, the second portion 13b is gradually higher than the first portion 13a along the height direction G1; and the second portion 13b covers the opening of the sound receiving hole 1007. Specifically, the protective mesh 13 is configured as a curved shape based on the above manner. The second portion 13b that is higher than the first portion 13a covers the opening of the sound receiving hole 1007. For example, in one embodiment, the first portion 13a covers a portion of the opening of the first recessed portion 1004, and the second portion 13b covers the opening of the sound receiving hole 1007 and the other portion of the first recessed portion 1004. Based on this, the sound receiving hole 1007, the first recessed portion 1004, and the pressure relief hole 1008 are completely covered by the protective mesh 13, so that the sound receiving hole 1007, the pressure relief hole 1008, and the first recessed portion 1004 can be effectively prevented from being clogged by sweat, rain, and other external factors, as well as effectively preventing other external particulate contaminants from entering the second accommodation cavity and causing damage to the air-conducting loudspeaker 12, thereby enhancing the operational stability of the earphone 100.

Optionally, as shown in FIG. 10 and FIG. 11, the sound receiving hole 1007 is formed on the support wall 1006, and the protective mesh 13 abuts against the support wall 1006. Specifically, the support wall 1006 serves as a portion of the shell assembly 10. The sound receiving hole 1007 is formed on the support wall 1006, and the support wall 1006 fits with the protective mesh 13 and supports the protective mesh 13, thereby effectively preventing the protective mesh 13 from collapsing under an external force, affecting the normal operation of the earphone 100, and thereby effectively enhancing the operational stability of the earphone 100. Optionally, the support wall 1006 may be a portion of the bottom of the shell assembly 10 that is recessed along the height direction G1. Along the height direction G1, the first recessed portion 1004 is located in a different plane from the support wall 1006. For example, along the height direction G1, the first recessed portion 1004 is higher than the support wall 1006, based on this, along the height direction G1, the sound receiving hole 1007 is provided at a position lower than the first recessed portion 1004, effectively preventing the first recessed portion 1004 from affecting the sound receiving operation of the sound receiving hole 1007 when the first recessed portion 1004 performs a pressure relief function.

Optionally, as shown in FIG. 9 and FIG. 10, the shell assembly 10 is provided with a second recessed portion 1009, and the protective mesh 13 is provided in the second recessed portion 1009. Specifically, the second recessed portion 1009 may be formed by an overall recess in a specific area of the bottom of the shell assembly 10 along the height direction G1, and the second recessed portion 1009 is configured to accommodate the protective mesh 13. An outer peripheral rim of the second recessed portion 1009 may be further recessed along the height direction G1, so that an outer peripheral rim of the protective mesh 13 abuts against and is fixedly connected to the outer peripheral rim of the second recessed portion 1009, e.g., the protective mesh 13 is fixedly connected to the second recessed portion 1009 by dispensing adhesive on the outer peripheral rim of the second recessed portion 1009. The second recessed portion 1009 accommodates and fixes the protective mesh 13. Based on this, an outer surface of the protective mesh 13 transitions smoothly with an outer surface of the shell assembly 10, thereby effectively enhancing the rounded and smooth shape of an outer contour of the earphone 100.

Optionally, as shown in FIG. 10 and FIG. 11, the protective mesh 13 includes a steel mesh 131, a gauze mesh 132, and a waterproof membrane 133. The side of the steel mesh 131 facing the opening of the pressure relief hole 1008 is provided with the gauze mesh 132, and the side of the gauze mesh 132 facing the opening of the pressure relief hole 1008 is provided with the waterproof membrane 133. Specifically, in one embodiment, the protective mesh 13 includes the steel mesh 131, the gauze mesh 132, and the waterproof membrane 133. The side of the steel mesh 131 facing the opening of the pressure relief hole 1008, i.e., the side of the steel mesh 131 near the pressure relief hole 1008 (also referred to as a side near the shell assembly 10) is provided with the gauze mesh 132. Based on this, the gauze mesh 132 can effectively prevent external particulate contaminants from entering the pressure relief hole 1008, thereby protecting the air-conducting loudspeaker 12 from damage. The side of the gauze mesh 132 facing the opening of the pressure relief hole 1008, i.e., the side of the gauze mesh 132 near the pressure relief hole 1008 (also referred to as a side near the shell assembly 10) is provided with the waterproof membrane 133. Based on this, the waterproof membrane 133 can effectively prevent external undesirable factors such as sweat, and rain from entering into the second accommodation cavity 1002 via the pressure relief hole 1008, thereby effectively protecting the air-conducting loudspeaker 12, and improving the operational stability of the earphone 100. Optionally, in one embodiment, the side of the gauze mesh 132 facing the opening of the pressure relief hole 1008 is provided with at least two layers of the waterproof membrane 133, thereby effectively improving the protective performance of the protective mesh 13.

Optionally, the mesh holes of the steel mesh 131 are smaller than the mesh holes of the gauze mesh 132. Based on this, it can effectively reduce the wind noise of the pressure relief hole 1008, thereby effectively improving the sound quality of the earphone 100.

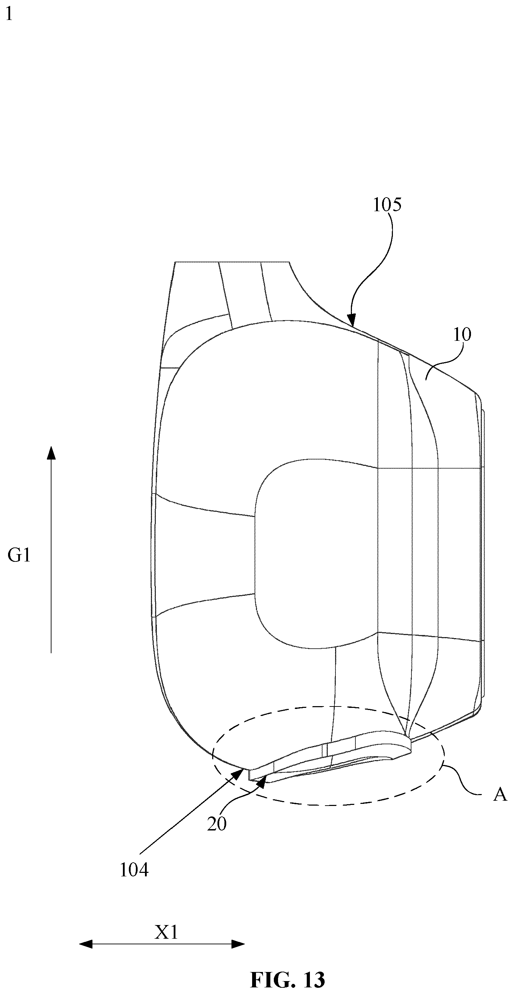

Optionally, as shown in FIG. 3, FIG. 13, FIG. 14, and FIG. 15, the present disclosure also presents a second embodiment of the pressure relief hole 1008 protection scheme. The second embodiment of the pressure relief hole 1008 protection scheme applies to the earphone 100 provided with both the bone-conducting loudspeaker 11 and the air-conducting loudspeaker 12, and it may also apply to the earphone 100 provided with the air-conducting loudspeaker 12 alone. Herein, the second embodiment of the pressure relief hole 1008 protection scheme is mainly described in terms of the earphone 100 provided with both the air-conducting loudspeaker 12 and the bone-conducting loudspeaker 11. The second embodiment of the pressure relief hole 1008 protection scheme is described as follows.

The loudspeaker assembly 1 includes the shell assembly 10, the loudspeaker, and a first annular protrusion 20. The shell assembly 10 is provided with an accommodation cavity, the shell assembly 10 is provided with the pressure relief hole 1008 for communicating with the accommodation cavity and the external environment, and the opening of the pressure relief hole 1008 is provided at the bottom 104 of the shell assembly 10 along the height direction G1. The loudspeaker is accommodated in the accommodation cavity; the first annular protrusion 20 is disposed around the opening of the pressure relief hole 1008 and extends downwardly from the bottom 104 of the shell assembly 10.

Specifically, as illustrated in FIG. 3, the accommodation cavity is used to accommodate the loudspeaker, and the accommodation cavity includes the first accommodation cavity 1001 and the second accommodation cavity 1002 spaced apart, the loudspeaker includes the air-conducting loudspeaker 12 and the bone-conducting loudspeaker 11, with the air-conducting loudspeaker 12 being accommodated in the second accommodation cavity 1002 and the bone-conducting loudspeaker 11 being accommodated in the first accommodation cavity 1001. Specific structures of the shell assembly 10 are described above, and will not be repeated herein in detail. In other embodiments, the accommodation cavity of the earphone 100 may be provided with only the air-conducting loudspeaker 12, which will not be described in detail herein. In one embodiment, the shell assembly 10 is provided with the pressure relief hole 1008 for a loudspeaker (e.g., the air-conducting loudspeaker 12) to relieve pressure, the pressure relief hole 1008 being in communication with the accommodation cavity (e.g., the second accommodation cavity 1002) and the external environment. Other relative positional relationships between the pressure relief hole 1008 and the accommodation cavity are described in the foregoing and will not be discussed in detail herein. Distinguishing from the above embodiments, in the present embodiment, the loudspeaker assembly 1 includes the first annular protrusion 20. The first annular protrusion 20 is disposed around an outer circumferential side of the opening of the pressure relief hole 1008 and extends downwardly from the bottom 104 of the shell assembly 10. The first annular protrusion 20 extending downwardly from the bottom 104 of the shell assembly 10 can be understood that the first annular protrusion 20 protrudes from a bottom surface of the shell assembly 10 along the height direction G1. Based on this, the first annular protrusion 20 can effectively prevent external undesirable factors such as sweat, and rain from flowing into the pressure relief hole 1008 and causing damage to the loudspeaker in the accommodation cavity, thereby effectively enhancing the operational stability of the earphone 100. The height direction G1 mentioned here and hereinafter is a direction along the bottom 104 of the shell assembly 10 to the top 105 of the shell assembly 10. Optionally, in some embodiments, the first annular protrusion 20 may be disposed around both the opening of the pressure relief hole 1008 and the outer circumferential side of the sound receiving hole 1007, which effectively prevents external undesirable factors such as sweat, and rain from flowing into the pressure relief hole 1008 and the sound receiving hole 1007 and causing damage to the loudspeaker in the accommodation cavity, thereby effectively improving the operational stability of the earphone 100.

Optionally, the first annular protrusion 20 is a metal ring or plastic ring, which is bonded to the bottom 104 of the shell assembly 10. Specifically, in some embodiments, the first annular protrusion 20 may be a structural member such as a metal ring or a plastic ring, which is fixedly connected to the shell assembly 10 using bonding agents like adhesive.

Optionally, the first annular protrusion 20 is an integrally molded structure with a portion of the shell assembly 10. Specifically, in some embodiments, a portion of the bottom of the shell assembly 10 that is located on an outer circumferential side of the opening of the pressure relief hole 1008 protrudes along the height direction away from the pressure relief hole 1008 to form the first annular protrusion 20. Based on this, the first annular protrusion 20 and the shell assembly 10 form an integrally-molded structure. In embodiments where the shell assembly 10 includes the shell 101, the shell 102, and the shell 103, the first annular protrusion 20 may be integrally molded with the shell 101, or the first annular protrusion 20 may be integrally molded with the shell 102; or, a portion of the first annular protrusion 20 may be integrally molded with the shell 101, and the other portion of the first annular protrusion 20 may be integrally molded with the shell 102. With the integrally-molded structure, the preparation process of the first annular protrusion 20 can be simplified, the structural strength of the first annular protrusion 20 can be strengthened, and the cost of production can be reduced.

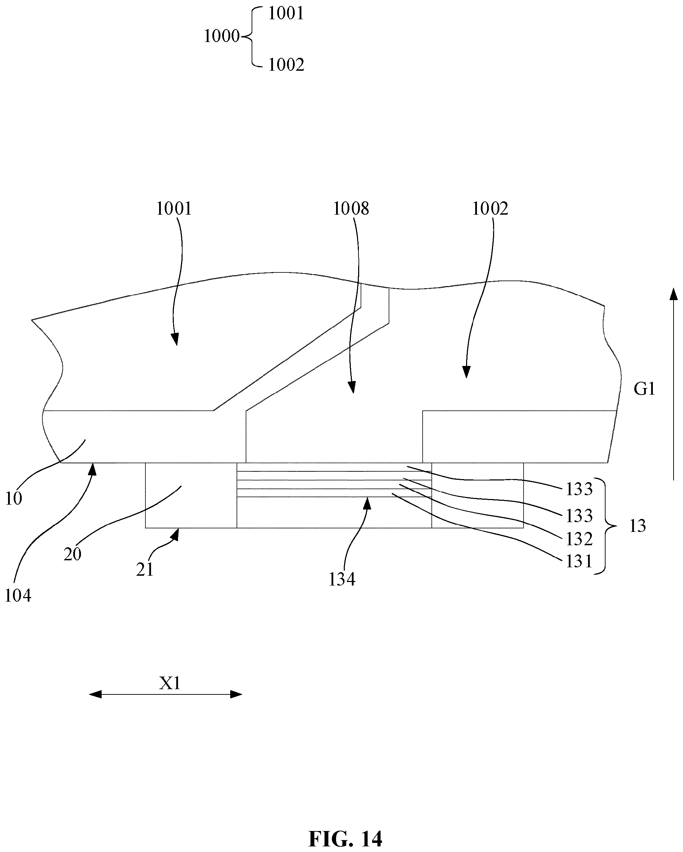

Optionally, as shown in FIG. 14, the earphone 100 further includes the protective mesh 13, the protective mesh 13 covering the opening of the pressure relief hole 1008. Along the height direction G1, the protective mesh 13 is higher than a bottom surface 21 of the first annular protrusion 20. Specifically, the protective mesh 13 is used to cover the opening of the pressure relief hole 1008 to prevent external undesirable factors such as sweat, and rain from entering the pressure relief hole 1008. Further, in some embodiments, the protective mesh 13 is higher than the bottom surface 21 of the first annular protrusion 20 along the height direction G1, i.e., there is a difference in height between a bottom surface 134 of the protective mesh 13 and the bottom surface 21 of the first annular protrusion 20 to allow the protective mesh 13 to be fully submerged in the region enclosed by the first annular protrusion 20 while the protective mesh 13 still exists a certain height difference. Such an arrangement can reduce the direct contact between external environmental factors such as rain, sweat, and the protective mesh 13 to some extent, thereby decreasing the likelihood of the pressure relief hole 1008 being infiltrated by external environmental factors such as rain, and sweat.

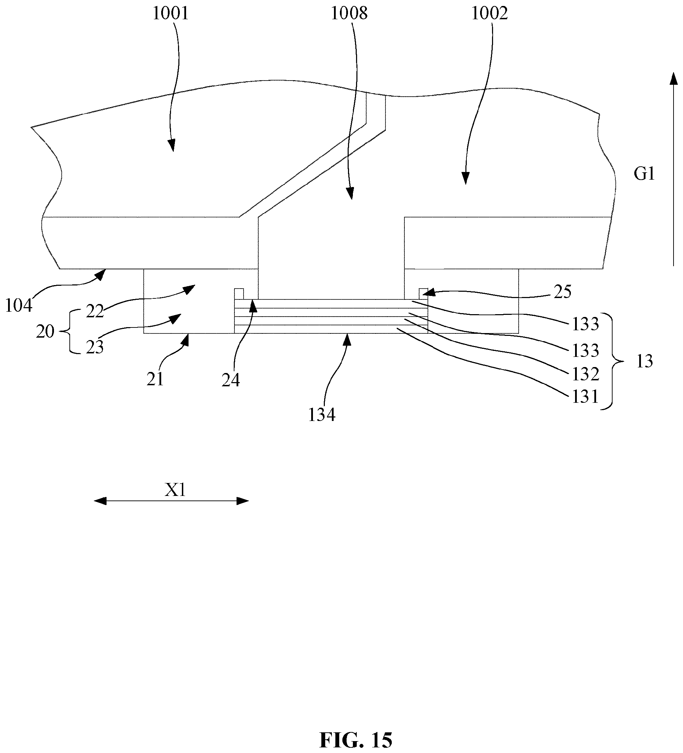

Optionally, as shown in FIG. 15, in other embodiments, the earphone 100 includes the protective mesh 13, and an inner side surface of the first annular protrusion 20 includes an annular support surface 24, the annular support surface 24 is connected to the protective mesh 13. Along the height direction G1, the bottom surface 134 of the protective mesh 13 is flush with the bottom surface 21 of the first annular protrusion 20. Specifically, in one embodiment, the first annular protrusion 20 includes a first portion 22 and a second portion 23 connected to the first portion 22 along the height direction G1, the first portion 22 being connected to the bottom 104 of the shell assembly 10; a cross-sectional dimension of an internal channel of the first portion 22 is smaller than a cross-sectional dimension of an internal channel of the second portion 23, and the annular support surface 24 is formed at a transition between the first portion 22 and the second portion 23. The annular support surface 24 protrudes from the pressure relief hole 1008, the annular support surface 24 is used to support the protective mesh 13 and is fixedly connected to the protective mesh 13, enabling the bottom surface 134 of the protective mesh 13 to flush with the bottom surface 21 of the first annular protrusion 20, i.e., the difference in height between the bottom surface 134 of the protective mesh 13 and the bottom surface 21 of the first annular protrusion 20 is zero. Based on this, it can effectively prevent external factors such as sweat, and rainwater from accumulating in the space between the bottom surface 134 of the protective mesh 13 and the bottom surface 21 of the first annular protrusion 20, thereby preventing the pressure relief hole 1008 from being clogged, thereby enhancing the operational stability of the earphone 100.

Optionally, as shown in FIG. 15, an outer rim of the annular support surface 24 is provided with an annular recess 25, and a bonding agent is disposed inside the annular recess 25. Specifically, the outer rim of the annular support surface 24 is the position where the annular support surface 24 is proximate to the second portion 23, and the annular support surface 24 is formed with an annular recess 25 at the position. An adhesive such as glue, etc. is disposed in the annular recess 25. The protective mesh 13 is connected to the annular support surface 24 by the adhesive, and can be effectively fixedly connected to the annular support surface 24.

Optionally, as shown in FIG. 14 and FIG. 15, the type of the protective mesh 13 is similar to that of the embodiments described above, i.e., the protective mesh 13 may include the steel mesh 131, the gauze mesh 132, and the waterproofing membrane 133, with the side of the steel mesh 131 facing the opening of the pressure relief hole 1008 being provided with the gauze mesh 132, and the side of the gauze mesh 132 facing the opening of the pressure relief hole 1008 being provided with the waterproof membrane 133. In other words, in one embodiment, the protective mesh 13 includes the steel mesh 131, the gauze mesh 132, and the waterproof membrane 133. The side of the steel mesh 131 facing the opening of the pressure relief hole 1008, i.e., the side of the steel mesh 131 near the pressure relief hole 1008 (also referred to as a side near the shell assembly 10) is provided with the gauze mesh 132. Based on this, the gauze mesh 132 can effectively prevent the outside particulate contaminants from entering the pressure relief hole 1008, thereby protecting the air-conducting loudspeaker 12 from damage. The side of the gauze mesh 132 facing the opening of the pressure relief hole 1008, i.e., the side of the gauze mesh 132 near the pressure relief hole 1008 (also referred to as a side near the shell assembly 10) is provided with the waterproof membrane 133. Based on this, the waterproof membrane 133 can effectively prevent external undesirable factors such as sweat, and rain from entering into the second accommodation cavity 1002 via the pressure relief hole 1008, thereby effectively protecting the air-conducting loudspeaker 12 and improving the operational stability of the earphone 100. Optimally, in one embodiment, a side of the gauze mesh 132 facing the opening of the pressure relief hole 1008 is provided with at least two layers of the waterproof membrane 133. Based on this, the protective performance of the protective mesh 13 can be effectively improved.

Optionally, the mesh holes of the steel mesh 131 are smaller than the mesh holes of the gauze mesh 132. Based on this, it can effectively reduce the wind noise of the pressure relief hole 1008, thereby effectively improving the sound quality of the earphone 100.

The foregoing is only a part of the embodiments of the present disclosure, and is not intended to limit the scope of protection of the present disclosure, and any equivalent device or equivalent process transformations utilizing the contents of the present disclosure and the accompanying drawings, or applying them directly or indirectly in other related technical fields, are similarly included in the scope of patent protection of the present disclosure.

The above is only an example of the present disclosure, and is not intended to limit the scope of the present disclosure, and any equivalent structure or equivalent process transformations utilizing the contents of the present disclosure and the accompanying drawings, or directly or indirectly applying them in other related technical fields, are included in the scope of the present disclosure.

## Claims

1. A loudspeaker assembly, comprising:
a shell assembly provided with a first accommodation cavity and a second accommodation cavity;
a bone-conducting loudspeaker accommodated in the first accommodation cavity; and
an air-conducting loudspeaker accommodated in the second accommodation cavity, the air-conducting loudspeaker including:
a magnetic circuit system including a magnet and a magnetic conduction assembly, the magnet being fixed on the magnetic conduction assembly, the magnetic conduction assembly being fixed in the second accommodation cavity, and the magnetic conduction assembly being provided with a weight reduction structure.

2. The loudspeaker assembly of claim 1, wherein the weight reduction structure includes at least one of a groove or a through hole arranged at the magnetic conduction assembly.

3. The loudspeaker assembly of claim 1, wherein a magnetic induction intensity at a position of the magnetic conduction assembly where the weight reduction structure is arranged is less than a magnetic induction intensity at other positions of the magnetic conduction assembly.

4. The loudspeaker assembly of claim 1, wherein
the magnetic conduction assembly includes a magnetic conduction shield and a magnetic conduction plate, the magnet being fixed in the magnetic conduction shield and the magnetic conduction plate being fixed to the magnet,
the weight reduction structure is arranged on at least one of the magnetic conduction shield or the magnetic conduction plate, there is one or more weight reduction structures on the magnetic conduction shield and the magnetic conduction plate of the magnetic conduction assembly, and a plurality of weight reduction structures are spaced apart.

5. The loudspeaker assembly of claim 4, wherein the magnetic conduction shield includes a bottom wall and an annular side wall extending from the bottom wall, and the weight reduction structure is arranged at the bottom wall.

6. The loudspeaker assembly of claim 4, wherein a total area of the weight reduction structure on the magnetic conduction shield accounts for less than or equal to 50% of an area of a bottom wall of the magnetic conduction shield, and a total area of the weight reduction structure on the magnetic conduction plate accounts for less than or equal to 50% of an area of the magnetic conduction plate.

7. The loudspeaker assembly of claim 4, wherein a total area of the weight reduction structure on the magnetic conduction shield accounts for less than or equal to 30% of an area of a bottom wall of the magnetic conduction shield, and a total area of the weight reduction structure on the magnetic conduction plate accounts for less than or equal to 30% of an area of the magnetic conduction plate.

8. The loudspeaker assembly of claim 6, wherein
a planar shape of the weight reduction structure on the magnetic conduction shield is the same as a planar shape of the bottom wall of the magnetic conduction shield and is reduced in equal proportion relative to the planar shape of the bottom wall of the magnetic conduction shield; and
a planar shape of the weight reduction structure on the magnetic conduction plate is the same as a planar shape of the magnetic conduction plate and is reduced in equal proportion relative to the planar shape of the magnetic conduction plate.

9. The loudspeaker assembly of claim 5, wherein the weight reduction structure is centrally arranged at the bottom wall.

10. The loudspeaker assembly of claim 4, wherein the weight reduction structure is centrally arranged at the magnetic conduction plate.

11. The loudspeaker assembly of claim 9 or claim 10, wherein the weight reduction structure is a through hole.

12. The loudspeaker assembly of claim 1, wherein the magnet is provided with the weight reduction structure, and the weight reduction structure is a groove or a through hole.

13. The loudspeaker assembly of claim 12, wherein a magnetic induction intensity at a position of the magnet where the weight reduction structure is arranged is less than a magnetic induction intensity at other positions of the magnet.

14. The loudspeaker assembly of claim 12 or claim 13, wherein the weight reduction structure on the magnet is located at a center of the magnet, and a planar shape of the weight reduction structure on the magnet is the same as a planar shape of the magnet and is reduced in equal proportion relative to the planar shape of the magnet.

15. The loudspeaker assembly of claim 12, wherein a planar area of the weight reduction structure on the magnet accounts for less than or equal to 50% of a planar area of the magnet.

16. The loudspeaker assembly of claim 1, wherein the air-conducting loudspeaker further includes a fixing assembly, the fixing assembly is fixed to the magnetic conduction assembly, and the fixing assembly is fixedly connected to the shell assembly.

17. The loudspeaker assembly of claim 16, wherein the air-conducting loudspeaker further includes a vibration diaphragm and a voice coil, a rim of the vibration diaphragm is connected to a periphery of the fixing assembly, and the voice coil is connected to the vibration diaphragm.

18. The loudspeaker assembly of any one of claims 1 to 10, 12, 13, and 15 to 17, wherein the loudspeaker assembly is provided with a pressure relief hole for communicating with the second accommodation cavity and external environment, and the pressure relief hole extends toward a side where the first accommodation cavity is located.

19. A wearable electronic device, comprising the loudspeaker assembly of any one of claims 1 to 18.

20. The wearable electronic device of claim 19, wherein the wearable electronic device is earphones, glasses, an AR device, or a VR device.
